# EUROPEAN PATENT SPECIFICATION

(11) **EP 3 882 977 B1**
(45) Date of publication and mention of the grant of the patent: **20.08.2025**
(21) Application number: 20212618.1
(22) Date of filing: 09.12.2020
(51) Int. Cl.: H10D 30/01, H10D 30/43, H10D 30/62, H10D 30/69, H10D 62/10, H10D 62/822, H10D 84/01, H10D 84/03, H10D 84/85, B82Y 10/00

(54) **FABRICATION OF NON-PLANAR SILICON GERMANIUM TRANSISTORS USING SILICON REPLACEMENT**
HERSTELLUNG VON NICHT-PLANAREN SILIZIUM-GERMANIUM-TRANSISTOREN MIT SILIZIUMERSATZ
FABRICATION DE TRANSISTORS NON PLANAIRES EN SILICIUM-GERMANIUM UTILISANT UN REMPLACEMENT DU SILICIUM

(30) Priority: 20.03.2020 US 202016824827
(43) Date of publication of application: 22.09.2021
(73) Proprietor: Intel Corporation, Santa Clara, CA 95054 (US)
(72) Inventor: KAVALIEROS, Jack T., Portland, OR 97229 (US); BOUCHE, Guillaume, Portland, OR 97219 (US); WEI, Andy Chih-Hung, Yamhill, OR 97148 (US)
(74) Representative: 2SPL Patentanwälte PartG mbB

(56) References cited:
- US-A1- 2007 090 416
- US-A1- 2015 357 190
- US-A1- 2017 047 419
- US-A1- 2020 006 530
- US-A1- 2020 006 533
- US-A1- 2020 043 806
- BASTRAKOVA M V ET AL: "The study of Si/Ge interdiffusion using molecular dynamics simulation", JOURNAL OF PHYSICS: CONFERENCE SERIES, vol. 1695, no. 1, 1 December 2020 (2020-12-01), GB, pages 012036, XP093188657, ISSN: 1742-6588, Retrieved from the Internet <URL:https://iopscience.iop.org/article/10.1088/1742-6596/1695/1/012036/pdf> DOI: 10.1088/1742-6596/1695/1/012036

## Description

### Technical Field

This disclosure relates generally to the field of semiconductor devices, and more specifically, to field-effect transistors (FETs) having non-planar architecture and containing silicon and germanium as channel materials.

### Background

A FET, e.g., a metal-oxide-semiconductor (MOS) FET (MOSFET), is a three-terminal device that includes source, drain, and gate terminals and uses electric field to control current flowing through the device. A FET typically includes a channel body of a semiconductor channel material, a source and a drain regions provided in the channel material, and a gate stack that includes at least a gate electrode material and may also include a gate dielectric material, the gate stack provided over a portion of the channel material between the source and the drain regions.

Recently, FETs with non-planar architectures, such as FinFETs (also sometimes referred to as "wrap-around gate transistors" or "tri-gate transistors") and nanoribbon/nanowire transistors (also sometimes referred to as "all-around gate transistors"), have been extensively explored as alternatives to transistors with planar architectures.

Introducing germanium into a silicon channel body to create a silicon germanium channel body may increase mobility of charge carriers in transistor devices and allow fabrication of P-type MOS (PMOS) transistors. However, fabricating complementary MOS (CMOS) integrated circuit (IC) devices having both silicon channel N-type MOS (NMOS) transistors and silicon germanium channel PMOS transistors in non-planar architectures on the same substrate, e.g., on the same bulk silicon substrate, is challenging.

US 2020/043806 A1 discloses a semiconductor structure including a portion of a substrate having a first well region and a second well region, an isolation region, a first fin and a second fin. The first fin may include a center region and a peripheral region surrounding the center region. The peripheral region of the first fin may include silicon germanium and the center region includes silicon and may be free of germanium.

US 2020/006533 A1 discloses a FinFET comprising a gate dielectric layer, and a gate electrode. A fin is formed by a semiconductor layer with a low germanium concentration. Further, the fin comprises germanium-rich layers formed in a second portion of the fin. As such, edge regions of the first portions and second portions of the fins have a higher germanium concentration than center regions of the first portions and second portions of the fins.

US 2007/090416 A1 discloses a CMOS device comprising a transistor of a first type on a first region on a first region and a transistor of a complementary type on a second region of substrate. A cladding is formed of a semiconductor having a narrower band gap than the semiconductor body. The substrate is comprised of a silicon semiconductor substrate having an undoped, or intrinsic epitaxial silicon region. A semiconductor film is ideally a silicon film.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a perspective view of an example FinFET, according to some embodiments of the disclosure.
FIGS. 2A-2D provide cross-sectional side views of IC structures having a silicon fin of a first FinFET as shown in FIG. 1 and a silicon germanium fin of a second FinFET as shown in FIG. 1 integrated over a single support structure using silicon replacement, according to various embodiments of the present disclosure.
FIG. 3 is a flow diagram of an example method of fabricating an IC structure having silicon FinFETs and silicon germanium FinFETs integrated over a single support structure using silicon replacement, according to some embodiments of the present disclosure.
FIGS. 4A-4J are various views illustrating different example stages in the fabrication of an IC structure having silicon FinFETs and silicon germanium FinFETs integrated over a single support structure using the method of FIG. 3, according to some embodiments of the present disclosure.
FIG. 5 is a perspective view of an example nanoribbon transistor, according to some embodiments of the disclosure, not forming part of the present invention.
FIG. 6 is a flow diagram of an example method of fabricating an IC structure having silicon nanoribbons and silicon germanium nanoribbons integrated over a single support structure using silicon replacement, according to some embodiments of the present disclosure, not forming part of the present invention.
FIGS. 7A-7F are various views illustrating different example stages in the fabrication of an IC structure having silicon nanoribbons and silicon germanium nanoribbons integrated over a single support structure using the method of FIG. 6, according to some embodiments of the present disclosure, not forming part of the present invention.
FIGS. 8A and 8B are top views of, respectively, a wafer and dies that may include one or more non-planar silicon germanium (SiGe) transistors fabricated using silicon replacement in accordance with any of the embodiments disclosed herein.
FIG. 9 is a cross-sectional side view of an IC package that may include one or more IC structures with one or more non-planar SiGe transistors fabricated using silicon replacement in accordance with any of the embodiments disclosed herein.
FIG. 10 is a cross-sectional side view of an IC structure assembly that may include one or more IC structures with one or more non-planar silicon germanium e transistors fabricated using silicon replacement in accordance with any of the embodiments disclosed herein.
FIG. 11 is a block diagram of an example computing device that may include one or more IC structures with one or more non-planar SiGe transistors fabricated using silicon replacement in accordance with any of the embodiments disclosed herein.

### Detailed Description

### Overview

For purposes of illustrating IC structures that include non-planar SiGe transistors fabricated using silicon replacement, proposed herein, it might be useful to first understand phenomena that may come into play in such devices. The following foundational information may be viewed as a basis from which the present disclosure may be properly explained. Such information is offered for purposes of explanation only and, accordingly, should not be construed in any way to limit the broad scope of the present disclosure and its potential applications. While some of the following descriptions may be provided for the example of transistors being implemented as FinFETs or nanoribbon transistors, embodiments of the present disclosure are equally applicable to transistor arrangements employing transistors of other nanowire architectures, such as nanowire or nanocomb transistors.

As described above, recently, FETs with non-planar architectures, such as FinFETs and nanoribbon transistors, have been extensively explored as alternatives to transistors with planar architectures.

In a FinFET, a semiconductor structure shaped as a fin extends away from a base (e.g., from a semiconductor substrate), and a gate stack wraps around the upper portion of the fin (i.e., the portion farthest away from the base), potentially forming a gate on 3 sides of the fin. The portion of the fin around which the gate stack wraps around is referred to as a "channel" or a "channel portion" of a FinFET. A semiconductor material of the channel portion is commonly referred to as a "channel material" of the transistor. A source region and a drain region are provided in the fin on the opposite sides of the gate stack, forming, respectively, a source and a drain of a FinFET.

In a nanoribbon transistor, a gate stack may be provided around a portion of an elongated semiconductor structure called "nanoribbon", potentially forming a gate on all sides of the nanoribbon. The "channel" or the "channel portion" of a nanoribbon transistor is the portion of the nanoribbon around which the gate stack wraps around. A source region and a drain region are provided in the nanoribbon on each side of the gate stack, forming, respectively, a source and a drain of a nanoribbon transistor. In some settings, the term "nanoribbon" has been used to describe an elongated semiconductor structure that has a rectangular transverse cross-section (i.e., a cross-section in a plane perpendicular to the longitudinal axis of the structure), while the term "nanowire" has been used to describe a similar structure but with a circular transverse cross-section. The term "nanocomb transistor" has been used to describe a transistor similar to a nanoribbon transistor in that it uses a nanoribbon as described above, but with the gate stack provided only on 3 of the 4 sides of the nanoribbon, potentially forming a gate on 3 sides of the nanoribbon. In the following, a term "nanoribbon-based transistor" is used to refer to any of a nanoribbon transistor, a nanowire transistor, a nanocomb transistor, or a transistor such as a nanoribbon, nanowire, or nanocomb transistor but having transverse cross-sections of any geometry (e.g., oval, or a polygon with rounded corners).

Fabricating CMOS devices having both non-planar silicon (Si) channel NMOS transistors (referred to herein as "Si transistors") and non-planar SiGe channel PMOS transistors (referred to herein as "SiGe transistors") on the same substrate, e.g., on the same bulk silicon substrate, is challenging. Taking nanoribbon transistors as an example, oftentimes, fabrication of a CMOS device having both Si channel nanoribbon transistors and SiGe channel nanoribbon transistors requires using different substrates for fabricating Si channel and SiGe channel transistors. Other times, it requires using differential stacks for NMOS transistors (i.e., the Si transistors) and PMOS transistors (i.e., the SiGe transistors). Often these differential stacks require different starting substrates and different epitaxial processes used to form them, increasing design complexity and fabrication costs. In addition, Si channel and SiGe channel nanoribbons formed using conventional techniques typically result in different heights of the nanoribbons for NMOS and PMOS transistors, leading to further challenges, e.g., in terms of encapsulation, etching, metallization, or packaging of such structures.

Described herein are IC structures/devices with non-planar SiGe transistors fabricated using silicon replacement. In general, silicon replacement as described herein, a process that may also be referred to as a "silicon replacement condensation technique," refers to providing, over a support structure (e.g., a substrate, a wafer, a chip, or a die), a channel body for a non-planar transistor, the channel body including silicon, providing a cladding layer that includes germanium (e.g., the cladding layer may take form of a Ge-rich SiGe material) over at least a portion of the channel body, and annealing the channel body so that at least some of the germanium of the cladding layer diffuses into the channel body. In context of the present disclosure, the channel body is a fin if the transistor is a FinFET transistor, and is a nanoribbon or a nanowire if the transistor is a nanoribbon-based transistor (i.e., a nanoribbon transistor, a nanowire transistor, or a nanocomb transistor). Following silicon replacement, the cladding layer (which may have become substantially oxide as a result of the anneal) may be removed. Fabricating non-planar SiGe transistors using silicon replacement advantageously allows forming IC structures with both silicon and SiGe transistors on a single support structure in a manner that is less complicated and costly compared to prior art implementations.

While some descriptions are provided herein with reference to nanoribbon transistors, these descriptions are equally applicable to embodiments of any nanoribbon-based transistors such as nanowire transistors, nanocomb transistors, or other non-planar FETs besides FinFETs, e.g., to nanoribbon transistors, nanowire transistors, or transistors such as nanoribbon, nanowire, or nanocomb transistors but having transverse cross-sections of any geometry (e.g., oval, or a polygon with rounded corners).

Each of the structures, packages, methods, devices, and systems of the present disclosure may have several innovative aspects, no single one of which being solely responsible for the all of the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art. For example, some descriptions may refer to a particular source (S) or drain (D) region or contact being either a source region/contact or a drain region/contact. However, unless specified otherwise, which region/contact of a transistor is considered to be a source region/contact and which region/contact is considered to be a drain region/contact is not important because under certain operating conditions, designations of source and drain are often interchangeable. Therefore, descriptions provided herein may use the term of a "S/D region/contact" to indicate that the region/contact can be either a source region/contact, or a drain region/contact. In another example, the term "high-k dielectric" refers to a material having a higher dielectric constant (k) than silicon oxide, while the term "low-k dielectric" refers to a material having a lower k than silicon oxide. If used, the terms "oxide," "carbide," "nitride," etc. refer to compounds containing, respectively, oxygen, carbon, nitrogen, etc. The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

In the present disclosure, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function. The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

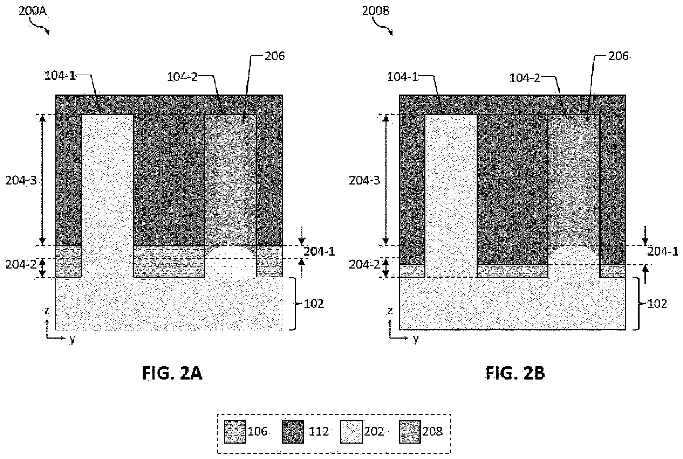

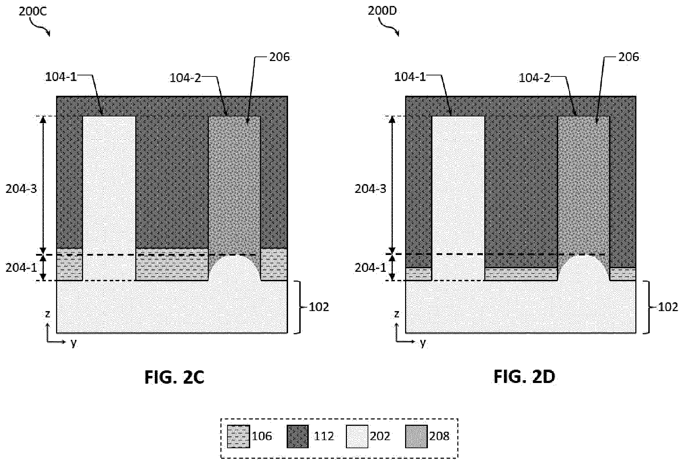

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 2A-2D, such a collection may be referred to herein without the letters, e.g., as "FIG. 2."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various transistor arrangements and IC structures with one or more non-planar SiGe transistors fabricated using silicon replacement as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

### Example FinFET

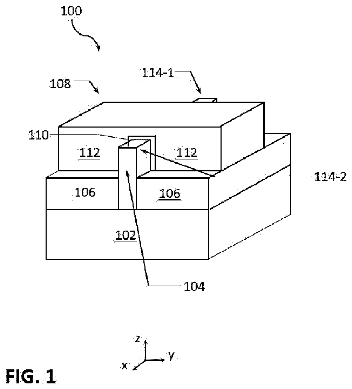

FIG. 1 is a perspective view of an example FinFET 100, according to some embodiments of the disclosure. The FinFET 100 illustrates an example structure for a non-planar SiGe transistor fabricated using silicon replacement as described herein. For example a plurality of fins with transistors such as the FinFETs 100 may be used to provide an IC structure having silicon FinFETs and silicon germanium FinFETs integrated over a single support structure using silicon replacement, as described with reference to FIGS. 2A-2D, FIG. 3, and FIGS. 4A-4J. The FinFET 100 shown in FIG. 1 is intended to show relative arrangement(s) of some of the components therein. In various embodiments, the FinFET 100, or portions thereof, may include other components that are not illustrated (e.g., any further materials, such as e.g. spacer materials, surrounding the gate stack of the FinFET 100, electrical contacts to the S/D regions of the FinFET 100, etc.).

As shown in FIG. 1, the FinFET 100 may be provided over a base 102, where the term "base" may refer to any suitable support structure on which a transistor may be built, e.g., a substrate, a die, a wafer, or a chip. As also shown in FIG. 1, the FinFET 100 may include a fin 104, extending away from the base 102. A portion of the fin 104 that is closest to the base 102 may be enclosed by an insulator material 106, commonly referred to as a "shallow trench isolation" (STI). The portion of the fin 104 enclosed on its' sides by the STI 106 is typically referred to as a "subfin portion" or simply a "subfin." As further shown in FIG. 1, a gate stack 108 that includes at least a layer of a gate electrode material 112 and, optionally, a layer of a gate dielectric 110, may be provided over the top and sides of the remaining upper portion of the fin 104 (e.g., the portion above and not enclosed by the STI 106), thus wrapping around the upper-most portion of the fin 104. The portion of the fin 104 over which the gate stack 108 wraps around may be referred to as a "channel portion" of the fin 104 because this is where, during operation of the FinFET 100, a conductive channel may form. The channel portion of the fin 104 is a part of an active region of the fin 104. A first S/D region 114-1 and a second S/D region 114-2 (also commonly referred to as "diffusion regions") are provided on the opposite sides of the gate stack 108, forming source and drain terminals of the FinFET 100.

In general, implementations of the present disclosure may be formed or carried out on a support structure such as a semiconductor substrate, composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. Although a few examples of materials from which the substrate may be formed are described here, any material that may serve as a foundation upon which one or more non-planar SiGe transistors fabricated using silicon replacement as described herein may be built falls within the spirit and scope of the present disclosure. In various embodiments, the base 102 may include any such substrate material that provides a suitable surface for forming the FinFET 100.

As shown in FIG. 1, the fin 104 may extend away from the base 102 and may be substantially perpendicular to the base 102. The fin 104 may include one or more semiconductor materials, e.g. a stack of semiconductor materials, so that the upper-most portion of the fin (namely, the portion of the fin 104 enclosed by the gate stack 108) may serve as the channel region of the FinFET 100. Therefore, as used herein, the term "channel material" of a transistor may refer to such upper-most portion of the fin 104, or, more generally, to any portion of one or more semiconductor materials in which a conductive channel between source and drain regions may be formed during operation of a transistor.

As shown in FIG. 1, the STI material 106 may enclose the sides of the fin 104. A portion of the fin 104 enclosed by the STI 106 forms a subfin. In various embodiments, the STI material 106 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 106 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

Above the subfin portion of the fin 104, the gate stack 108 may wrap around the fin 104 as shown in FIG. 1. In particular, the gate dielectric 110 may wrap around the upper-most portion of the fin 104, and the gate electrode 112 may wrap around the gate dielectric 110. The interface between the channel portion of the fin 104 and the subfin portion of the fin 104 is located proximate to where the gate electrode 112 ends.

The gate electrode 112 may include one or more gate electrode materials, where the choice of the gate electrode materials may depend on whether the FinFET 100 is a PMOS transistor or an NMOS transistor. For a PMOS transistor, gate electrode materials that may be used in different portions of the gate electrode 112 may include, but are not limited to, ruthenium, palladium, platinum, cobalt, nickel, and conductive metal oxides (e.g., ruthenium oxide). For an NMOS transistor, gate electrode materials that may be used in different portions of the gate electrode 112 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 112 may include a stack of a plurality of gate electrode materials, where zero or more materials of the stack are workfunction (WF) materials and at least one material of the stack is a fill metal layer. Further materials/layers may be included next to the gate electrode 112 for other purposes, such as to act as a diffusion barrier layer or/and an adhesion layer.

If used, the gate dielectric 110 may include a stack of one or more gate dielectric materials. In some embodiments, the gate dielectric 110 may include one or more high-k dielectric materials. In various embodiments, the high-k dielectric materials of the gate dielectric 110 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 110 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 110 during manufacture of the FinFET 100 to improve the quality of the gate dielectric 110.

In some embodiments, the gate stack 108 may be surrounded by a dielectric spacer, not specifically shown in FIG. 1. The dielectric spacer may be configured to provide separation between the gate stacks 108 of different FinFETs 100 which may be provided along a single fin (e.g., different FinFETs provided along the fin 104, although FIG. 1 only illustrates one of such FinFETs), as well as between the gate stack 108 and the source/drain contacts disposed on each side of the gate stack 108. Such a dielectric spacer may include one or more low-k dielectric materials. Examples of the low-k dielectric materials that may be used as the dielectric spacer include, but are not limited to, silicon dioxide, carbon-doped oxide, silicon nitride, fused silica glass (FSG), and organosilicates such as silsesquioxane, siloxane, and organosilicate glass. Other examples of low-k dielectric materials that may be used as the dielectric spacer include organic polymers such as polyimide, polynorbornenes, benzocyclobutene, perfluorocyclobutane, or polytetrafluoroethylene (PTFE). Still other examples of low-k dielectric materials that may be used as the dielectric spacer include silicon-based polymeric dielectrics such as hydrogen silsesquioxane (HSQ) and methylsilsesquioxane (MSQ). Other examples of low-k materials that may be used in a dielectric spacer include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1. When such a dielectric spacer is used, then the lower portions of the fin 104, e.g., the subfin portion of the fin 104, may be surrounded by the STI material 106 which may, e.g., include any of the high-k dielectric materials described herein.

In various embodiments, the fin 104 may be composed of semiconductor material systems including, for example, N-type or P-type materials systems. In some embodiments, the fin 104 may include a combination of semiconductor materials where one semiconductor material is used for the channel portion and another material, sometimes referred to as a "blocking material," is used for at least a portion of the subfin portion of the fin 104. For example, the subfin of the fin 104 may be a material having a band offset (e.g., valance band offset for PMOS transistors or conduction band offset for NMOS devices) from the channel portion. In some embodiments, the channel portion of the fin 104 may be an intrinsic semiconductor material, i.e., a semiconductor material not intentionally doped with any electrically active impurity. In alternate embodiments, a nominal impurity dopant level may be present within the channel portion of the fin 104, for example to further fine-tune a threshold voltage (Vt), to provide HALO pocket implants, etc. Even for impurity-doped embodiments however, impurity dopant level within the channel portion of the fin 104 may be relatively low, for example below 10¹⁵ dopant atoms per cubic centimeter (cm⁻³), and advantageously below 10¹³ cm⁻³. When the FinFET 100 is an NMOS transistor, the channel portion of the fin 104 may advantageously include silicon, e.g., a monocrystalline Si. When the FinFET 100 is a PMOS transistor, the channel portion of the fin 104 may advantageously include a semiconductor material that includes silicon and germanium, e.g., Si₁₋ₓGeₓ, where Ge content (x) may be at least about 0.2, e.g., between about 0.2 and 0.6. In other example embodiments, the channel portion of the fin 104 may have a Ge content between about 0.6 and 0.9, e.g., at least about 0.7. In some P-type transistor embodiments, the subfin of the fin 104 may be Si and at least a portion of the subfin may also be doped with impurities (e.g., N-type) to a higher impurity level than the channel portion. The fin SiGe to subfin Si interface may induce a compressive strain on the SiGe fin portion, enhancing hole mobility in the PMOS transistor.

Turning to the first S/D region 114-1 and the second S/D region 114-2 on respective different sides of the gate stack 108, in some embodiments, the first S/D region 114-1 may be a source region and the second S/D region 114-2 may be a drain region. In other embodiments this designation of source and drain may be interchanged, i.e., the first S/D region 114-1 may be a drain region and the second S/D region 114-2 may be a source region. Although not specifically shown in FIG. 1, the FinFET 100 may further include S/D electrodes (also commonly referred to as "S/D contacts"), formed of one or more electrically conductive materials, for providing electrical connectivity to the S/D regions 114, respectively. In some embodiments, the S/D regions 114 of the FinFET 100 may be regions of doped semiconductors, e.g., regions of doped channel material of the fin 104, so as to supply charge carriers for the transistor channel. In some embodiments, the S/D regions 114 may be highly doped, e.g. with dopant concentrations of about 1·10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions 114 of the FinFET 100 are the regions having dopant concentration higher than in other regions, e.g., higher than a dopant concentration in a region of the semiconductor channel material between the first S/D region 114-1 and the second S/D region 114-2, and, therefore, may be referred to as "highly doped" (HD) regions.

In some embodiments, the S/D regions 114 may generally be formed using either an implantation/diffusion process or an etching/deposition process. In the former process, dopants such as boron, aluminum, antimony, phosphorous, or arsenic may be ion-implanted into the one or more semiconductor materials of the upper portion of the fin 104 to form the S/D regions 114. An annealing process that activates the dopants and causes them to diffuse further into the fin 104 may follow the ion implantation process. In the latter process, the one or more semiconductor materials of the fin 104 may first be etched to form recesses at the locations for the future source and drain regions. An epitaxial deposition process may then be carried out to fill the recesses with material (which may include a combination of different materials) that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. Although not specifically shown in the perspective illustration of FIG. 1, in further embodiments, one or more layers of metal and/or metal alloys may be used to form the source and drain contacts (i.e., electrical contacts to each of the S/D regions 114).

The FinFET 100 may have a gate length, GL, (i.e. a distance between the first S/D region 114-1 and the second S/D region 114-2), a dimension measured along the fin 104 in the direction of the x-axis of the example reference coordinate system x-y-z shown in FIG. 1, which may, in some embodiments, be between about 5 and 40 nanometers, including all values and ranges therein (e.g. between about 22 and 35 nanometers, or between about 15 and 25 nanometers). The fin 104 may have a thickness, a dimension measured in the direction of the y-axis of the reference coordinate system x-y-z shown in FIG. 1, that may, in some embodiments, be between about 4 and 15 nanometers, including all values and ranges therein (e.g. between about 5 and 10 nanometers, or between about 7 and 12 nanometers). The fin 104 may have a height, a dimension measured in the direction of the z-axis of the reference coordinate system x-y-z shown in FIG. 1, which may, in some embodiments, be between about 30 and 350 nanometers, including all values and ranges therein (e.g. between about 30 and 200 nanometers, between about 75 and 250 nanometers, or between about 150 and 300 nanometers).

Although the fin 104 illustrated in FIG. 1 is shown as having a rectangular cross-section in a z-y plane of the reference coordinate system shown in FIG. 1, the fin 104 may instead have a cross-section that is rounded or sloped at the "top" of the fin 104, and the gate stack 108 (including the different portions of the gate dielectric 110) may conform to this rounded or sloped fin 104. In use, the FinFET 100 may form conducting channels on three "sides" of the channel portion of the fin 104, potentially improving performance relative to single-gate transistors (which may form conducting channels on one "side" of a channel material or substrate) and double-gate transistors (which may form conducting channels on two "sides" of a channel material or substrate).

While FIG. 1 illustrates a single FinFET 100, in some embodiments, a plurality of FinFETs may be arranged next to one another (with some spacing in between) along the fin 104.

### Example FinFET arrangements with SiGe transistors

FIGS. 2A-2D provide cross-sectional side views (i.e., the views of the y-z plane of the example reference coordinate system shown in FIG. 1) of IC structures 200 having a silicon fin of a first FinFET as shown in FIG. 1 and a silicon germanium fin of a second FinFET as shown in FIG. 1 integrated over a single support structure using silicon replacement, according to various embodiments of the present disclosure. The IC structures shown in FIGS. 2A-2D are intended to show relative arrangement(s) of some of the components therein and in various embodiments, the IC structures shown in FIGS. 2A-2D, or portions thereof, may include other components that are not illustrated (e.g., any further materials, such as spacer materials, S/D regions or electrical contacts thereto, etc.). Same holds for subsequent drawings of the present disclosure. A legend provided within a dashed box at the bottom of FIGS. 2A-2D illustrates colors/patterns used to indicate some portions or materials of some of the elements shown in FIGS. 2A-2D, so that the drawings are not cluttered by too many reference numerals (the same holds for subsequent drawings of the present disclosure that include a legend at the bottom of the drawings). For example, FIGS. 2A-2D use different colors/patterns to identify the STI 106, the gate electrode material 112, a material 202 of the base 102, a SiGe material 208, etc.

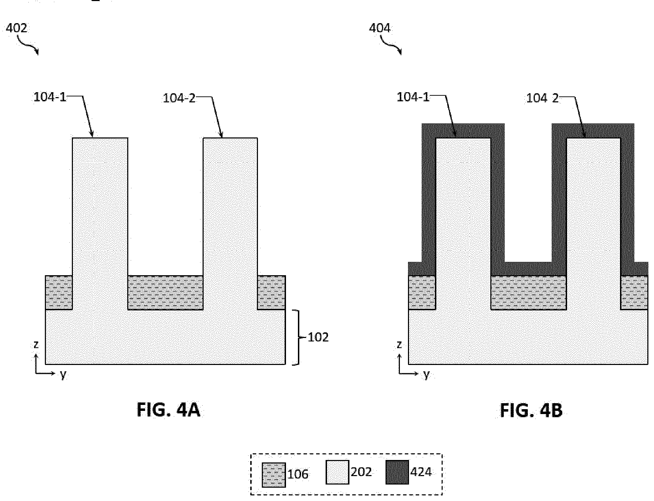

The IC structures shown in FIGS. 2A-2D, as well as in FIGS. 4A-4J, are examples of how a plurality of the FinFETs 100 may be arranged in an IC structure. Therefore, the IC structures shown in FIGS. 2A-2D, as well as in FIGS. 4A-4J illustrate some elements labeled with the same reference numerals as those used in FIG. 1 to indicate similar or analogous elements in these drawings, so that, in the interests of brevity, descriptions of a given element provided with reference to one drawing does not have to be repeated again for other drawings. For example, FIGS. 2A-2D and FIGS. 4A-4J illustrate the fin 104 (in particular, a plurality of such fins), the STI 106, and the gate electrode material 112. The same holds for subsequent drawings of the present disclosure - elements with reference numerals used in one drawing and shown again in another drawing refer to similar or analogous elements so that their descriptions do not have to be repeated for each drawing.

FIG. 2A illustrates an IC structure 200A that includes at least two fins, shown as a first fin 104-1 and a second fin 104-2. Both the first and the second fins 104 may extend away from the base 102, as was described with reference to FIG. 1. The first fin 104-1 may include substantially the same material as that of the base 102, e.g., silicon, e.g., monocrystalline silicon, shown as a silicon material 202, while at least a portion of the second fin 104-2 may include at least one SiGe material. In particular, the embodiment shown in FIG. 2A illustrates a first portion 204-1 of the second fin 104-2, a second portion 204-2 of the second fin 104-2, and a third portion 204-3 of the second fin 104-2.

The second portion 204-2 is the portion closest to the base 102 and may include substantially the same material as the base 102, e.g., the silicon material 202.

The third portion 204-3 is the portion farthest away from the base 102, compared to the first and second portions 204-1, 204-2. This is the portion of the fin 104-2 around which the gate stack 108 is provided, as shown in FIG. 2A with the gate electrode material 112 surrounding the third portion 204-3 (although not specifically shown in FIG. 2A, in some embodiments, the IC structure 200A may also include the gate dielectric 110 between the second fin 104-2 and the gate electrode material 112, as described with reference to FIG. 1). The third portion 204-3 of the second fin 104-2 includes a SiGe material 208. As shown in FIG. 2A, in some embodiments, a portion of the SiGe material 208 shown in FIG. 2A as a portion 206 indicated with dots in the SiGe material 208 near the sidewalls and the top of the second fin 104-2 may have a higher germanium concentration than the rest of the SiGe material 208 (e.g., than the central portion of the SiGe material 208 in the second fin 104-2). Thus, in some embodiments, a higher germanium concentration portion 206 of the SiGe material 208 may be between the SiGe material 208 in the center of the second fin 104-2 and the gate electrode material 112. In some embodiments, a concentration of germanium of the SiGe material 208 in the portion 206 (i.e., near the sidewalls of the third portion 204-3 of the second fin 104-2) may be at least about 2 times higher, including all values and ranges therein, e.g., at least about 3 times higher, e.g., about 5 times higher, than the concentration of germanium in the SiGe material 208 (i.e., in the middle of the third portion 204-3 of the second fin 104-2). The gradient in concentrations of germanium between the SiGe material 208 in the outer portion 206 of the second fin 104-2 and the SiGe material 208 in the central portion of the fin 104-2 may be one of the characteristic features of using silicon replacement to form a SiGe fin based on which one or more FinFETs may be formed. In some embodiments, the atomic percentage of germanium in the SiGe material 208 may be between about 20 and 50%, e.g., the atomic percentage of germanium in the SiGe material 208 may be at least about 20%. In some such embodiments, the remaining percentage of atoms may be silicon atoms, possibly with some impurities in negligible amounts. For example, in some embodiments, the atomic percentage of silicon in the SiGe material 208 may be between about 50 and 80%, e.g., the atomic percentage of silicon in the SiGe material 208 may be at most about 80%. On the other hand, the silicon material 202 may include silicon in higher concentrations than the SiGe material 208. For example, in some embodiments, a concentration of silicon in the silicon material 202 may be at least about 2 times higher, including all values and ranges therein, than in the SiGe material 208. For example, in some embodiments, the atomic percentage of silicon in the silicon material 202 may be between about 90 and 100%, e.g., the atomic percentage of silicon in the silicon material 202 may be at least about 80 or 85%.

The first portion 204-1 of the second fin 104-2 may be the portion between the second portion 204-2 and the third portion 204-3. As shown in FIG. 2A, a part of the fin 104-2 near the sidewalls of the first portion 204-1 includes the SiGe material 208, e.g., having a shape of a tail as shown in FIG. 2A, with the amount of germanium decreasing towards the base 102. On the other hand, the middle part of the first portion 204-1 of the second fin 104-2 may include substantially the silicon material 202 of the base 102. While FIG. 2A illustrates that the first portion 204-1 of the second fin 104-2 includes the SiGe material 208 in higher concentration (as in the portion 206, described above), in other embodiments (not specifically shown in FIG. 2A), the first portion 204-1 may include the SiGe material 208 in lower concentrations (as the material in the center of the second fin 104-2, described above) near the sidewalls of the fin 104-2. The tail shape in concentrations of germanium in the SiGe material 208 at the sidewalls of the first portion 204-1 of the fin 104-2 decreasing from the third portion 204-3 towards the second portion 204-2 is another one of the characteristic features of using silicon replacement to form a SiGe fin based on which one or more FinFETs may be formed.

In some embodiments of the IC structure 200A, the height (i.e., a dimension measured along the z-axis of the example coordinate system shown) of the third portion 204-3 of the second fin 104-2 may be between about 60 and 90% of the total height of the second fin 104-2. The remaining portion of the height of the second fin 104-2 may include the heights of the first and second portions 204-1, 204-2. In some embodiments, the height of the second portion 204-2 of the second fin 104-2 of the IC structure 200A may be between about 50 and 80% of the total height of the second fin 104-2.

In some embodiments, the STI 106 may be in contact with the sidewalls of both the first and the second portions 204-1, 204-2 of the second fin 104-2, as shown in FIG. 2A. In other embodiments, the STI 106 may be recessed so that at least a portion of the first portion 204-1 of the second fin 104-2 is not surrounded by the STI 106. In such embodiments, the portion of the first portion 204-1 of the second fin 104-2 that is not surrounded by the STI 106 may be surrounded by the gate electrode material 112. Such an embodiment is shown in an IC structure 200B of FIG. 2B. The IC structure 200B shown in FIG. 2B is substantially the same as the IC structure 200A shown in FIG. 2A except that in the IC structure 200B the first portion 204-1 of the second fin 104-2 is not surrounded by the STI 106 but is surrounded by the gate electrode material 112. The rest of the descriptions provided with respect to FIG. 2A are applicable to the IC structure 200B of FIG. 2B and, in the interests of brevity, are not repeated here.

FIG. 2C illustrates an IC structure 200C that is substantially the same as the IC structure 200A shown in FIG. 2A except that in the IC structure 200C the first portion 204-1 of the second fin 104-2 extends further towards the base 102 so that the second portion 204-2 is no longer there. In such embodiments, all of the first portion 204-1 may be enclosed by the STI 106, as shown in FIG. 2C. In some embodiments of the IC structure 200C, all of the third portion 204-3 of the second fin 104-2 may be the SiGe material 208 having a higher Ge concentration, as shown in FIG. 2C with dots in the SiGe material 208. In some embodiments of the IC structure 200C, the height of the third portion 204-3 of the second fin 104-2 may be between about 70 and 90% of the total height of the second fin 104-2, with the remaining portion of the height of the second fin 104-2 being the height of the first portion 204-1. The rest of the descriptions provided with respect to FIG. 2A are applicable to the IC structure 200C of FIG. 2C and, in the interests of brevity, are not repeated here.

FIG. 2D illustrates an IC structure 200D that is substantially the same as the IC structure 200C shown in FIG. 2C except that in the IC structure 200D some of the first portion 204-1 of the second fin 104-2 is not is not surrounded by the STI 106 (i.e., the STI 106 is recessed in the IC structure 200D, similar to the IC structure 200B). In such embodiments, the portion of the first portion 204-1 of the second fin 104-2 that is not surrounded by the STI 106 may be surrounded by the gate electrode material 112, as shown in FIG. 2D. The rest of the descriptions provided with respect to FIG. 2C are applicable to the IC structure 200D of FIG. 2D and, in the interests of brevity, are not repeated here.

In other embodiments, the SiGe material 208 of the IC structures 200C and 200C may be the SiGe material 208 with lower Ge concentration as described above (i.e., the SiGe material 208 shown in FIGS. 2C and 2D may be without the dots shown in these figures).

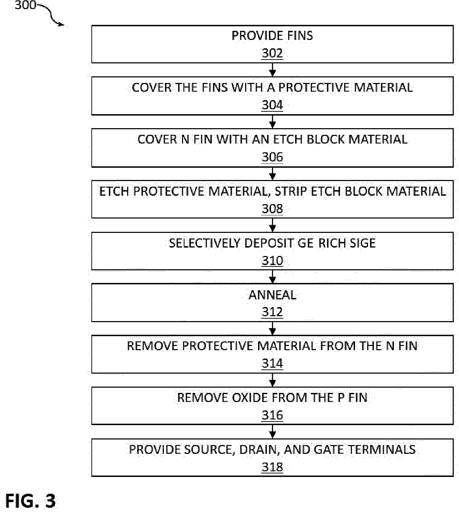

FIG. 3 is a flow diagram of an example method 300 of fabricating an IC structure (e.g., any embodiments of the IC structures 200 shown in FIGS. 2A-2D) having silicon FinFETs and silicon germanium FinFETs integrated over a single support structure using silicon replacement, according to some embodiments of the present disclosure.

Although the operations of the method 300 are illustrated once each and in a particular order, the operations may be performed in any suitable order and repeated as desired. For example, one or more operations may be performed in parallel to manufacture, substantially simultaneously, multiple IC structures and/or multiple SiGe FinFETs as described herein. In another example, the operations may be performed in a different order to reflect the structure of a particular device assembly in which one or more non-planar SiGe transistors fabricated using silicon replacement as described herein will be included.

In addition, the example manufacturing method 300 may include other operations not specifically shown in FIG. 3, such as various cleaning or planarization operations as known in the art. For example, in some embodiments, the base 102, as well as layers of various other materials subsequently deposited thereon, may be cleaned prior to, after, or during any of the processes of the method 300 described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the arrangements/devices described herein may be planarized prior to, after, or during any of the processes of the method 300 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Various operations of the method 300 may be illustrated with reference to the example embodiments shown in FIGS. 4A-4J, illustrating fabrication of the IC structures 200 according to various embodiments described above, but the method 300 may be used to manufacture any suitable IC structures having one or more non-planar SiGe transistors fabricated using silicon replacement according to any embodiments of the present disclosure. FIGS. 4A-4J illustrate cross-sectional side views similar to the view shown in FIGS. 2A-2D (i.e., a cross-section along the y-z plane), in various example stages in the manufacture of an IC structure having silicon FinFETs and silicon germanium FinFETs integrated over a single support structure using the method of FIG. 3 in accordance with some embodiments of the present disclosure.

The method 300 may begin with providing a plurality of fins over a base (process 302 shown in FIG. 3, a result of which is illustrated with an IC structure 402, shown in FIG. 4A). The IC structure 402 illustrates the base 102 and two fins 104 (namely, the first fin 104-1 and the second fin 104-2, as described above) extending away from the base 102, with lower portions of the fins being enclosed by the STI 106, while the upper portions of the fins being exposed. At this point, both of the fins 104 may be made of the silicon material 202, i.e., the material of the base 102. Methods for providing the fins 104 are known in the art and, therefore, are not described here in detail.

The method 300 may then proceed with providing a protective material over the fins (process 304 shown in FIG. 3, a result of which is illustrated with an IC structure 404, shown in FIG. 4B). The IC structure 404 illustrates a protective material 424 provided as a layer over the fins 104. The protective material 424 may include any suitable material that can protect the silicon material 202 of the N fin (i.e., the fin over which NMOS transistors are to be formed, which is the first fin 104-1 in the example described herein) from being converted to a silicon germanium material in later processes of the method 300. In some embodiments, the protective material 424 may include one or more of dielectric materials selective to epitaxial SiGe growth such as oxide, SiN, SiOC, SiOCN, Al3O2, HfO2, ZrO2, etc. In some embodiments, the protective material 424 may be provided using a conformal deposition technique such as one or more of atomic layer deposition(ALD), chemical vapor deposition (CVD), plasma enhanced CVD (PECVD), or/and physical vapor deposition (PVD) processes such as e.g. sputter. However, in other embodiments, any other suitable deposition techniques may be used to provide the protective material 424 over the fins 104 provided in 302, such as spin-coating or dip-coating.

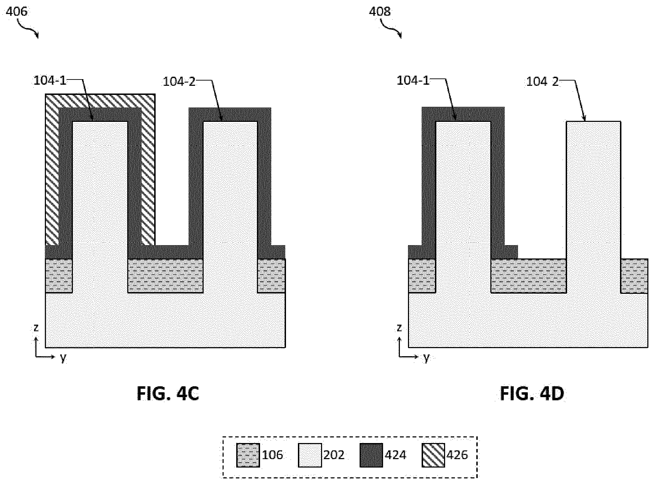

The method 300 may then include providing an etch block material over the N fin (process 306 shown in FIG. 3, a result of which is illustrated with an IC structure 406, shown in FIG. 4C). The IC structure 406 illustrates an etch block material 426 provided over the protective material 424 provided over the first fin 104-1. The etch block material 426 may include any suitable material that is etch selective with respect to the protective material 424, meaning that the etch block material 426 and the protective material 424 are selected so that etchants that may be used to etch the protective material 424 do not substantially etch the etch block material 426. In some embodiments, the etch block material 426 may include one or more of lithographic patterning materials such as carbon hardmask, anti-reflective coatings, SiN, SiON, photoresist, etc. In some embodiments, the etch block material 426 may be provided using spin-on or any of the conformal deposition techniques described above. Although not specifically shown in FIG. 4C, in various embodiments, any suitable patterning techniques may be used in the process 306 to define the locations and the dimensions of the etch block material 426, such as, but not limited to, photolithographic or electron-beam (e-beam) patterning, possibly in conjunction with the use of one or more masks.

The method 300 may then include etching the protective material 424 that is not protected with the etch block material 426 and, following the etch, removing the etch block material 426 (process 308 shown in FIG. 3, a result of which is illustrated with an IC structure 408, shown in FIG. 4D). The IC structure 408 illustrates that the silicon material 202 of the P fin (i.e., the fin over which PMOS transistors are to be formed, which is the second fin 104-2 in the example described herein) is now exposed because the protective material 424 has been etched away. The IC structure 408 also illustrates that the etch block material 426 has been removed from the N fin 104-1. In some embodiments, process 308 may include performing an isotropic etch such as a wet etch using any suitable etchants. In other embodiments, process 308 may include performing an anisotropic etch. In some embodiments, the anisotropic etch of the process 308 may include an etch that uses etchants in a form of e.g., chemically active ionized gas (i.e., plasma) using e.g., bromine (Br) and chloride (CI) based chemistries. In some embodiments, during the etch of the process 308, the IC structure may be heated to elevated temperatures, e.g., to temperatures between about room temperature and 200 degrees Celsius, including all values and ranges therein, to promote that byproducts of the etch are made sufficiently volatile to be removed from the surface. In some embodiments, the anisotropic etch of the process 308 may include a dry etch, such as radio frequency (RF) reactive ion etch (RIE) or inductively coupled plasma (ICP) RIE.

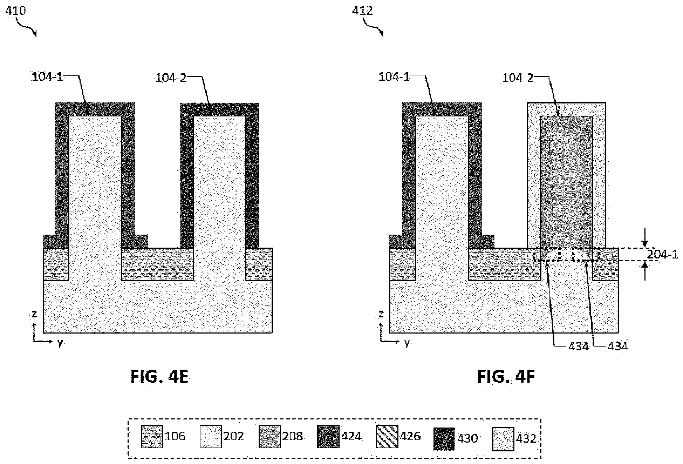

The method 300 may then proceed with performing selective deposition of a Ge-rich SiGe cladding over the P fin (process 310 shown in FIG. 3, a result of which is illustrated with an IC structure 410, shown in FIG. 4E). The IC structure 410 illustrates a Ge-rich SiGe cladding 430 provided over the top and the sidewalls of the second fin 104-2. In some embodiments, the Ge-rich SiGe cladding 430 may be a semiconductor material that includes Si and Ge atoms, with the atomic concentration of the Ge atoms being between about 20 and 80%, including all values and ranges therein. In some embodiments, deposition of the Ge-rich SiGe cladding 430 may be selective to the protective material 424 and the STI 106 (e.g., may be selective to the insulator materials used in the protective material 424 and the STI 106), which means that the cladding 430 may be selectively deposited on the sidewalls and the top of the second fin 104-2 but not the protective material 324 or the STI 106. In some embodiments, the deposition of the Ge-rich SiGe cladding 430 may be conformal on the second fin 104-2, as shown in FIG. 4E, or faceted (not specifically shown in the present drawings). In various embodiments, the Ge-rich SiGe cladding 430 may be a crystalline material, such as single crystal or polycrystalline configurations. In other embodiments, the Ge-rich SiGe cladding 430 may be amorphous (e.g., provided by amorphous deposition) to provide a conformal profile as depicted in FIG. 4E. Selective deposition of the Ge-rich SiGe cladding 430 to provide an amorphous configuration may be performed using any suitable technique such as gas source molecular beam epitaxy (GS-MBE), CVD, or rapid thermal CVD (RT-CVD). Selective deposition of the Ge-rich SiGe cladding 430 to provide a crystalline configuration may be performed using germane and applying deposition temperatures of up to 500 degrees Celsius.

Next, the method 300 may include annealing the IC structure formed in the process 310 to oxidize the Ge-rich SiGe cladding provided over the P fin (process 312 shown in FIG. 3, a result of which is illustrated with an IC structure 412, shown in FIG. 4F). The IC structure 412 illustrates that, as a result of the anneal, the germanium diffuses from the Ge-rich SiGe cladding 430 provided over the top and the sidewalls of the second fin 104-2 into the silicon material 202 of the second fin 104-2, thereby replacing the Si atoms in the silicon material 202 with Ge atoms (hence, the term "silicon replacement"), effectively converting the silicon material 202 into a SiGe semiconductor material. Because Ge atoms are leaving the Ge-rich SiGe cladding 430 during the anneal of the process 310, the Ge-rich SiGe cladding 430 may be converted to an oxide material 432. In some embodiments, the process 312 may include performing an anneal of the IC structure 410 at oxidation conditions (e.g., in oxygen ambient), using temperatures of about 450 degrees Celsius with wet and/or plasma-assisted oxidation, up to about 1200 degrees Celsius, possibly with a slow cooling ramp. In some embodiments, the process 312 may include performing an anneal of the IC structure 410 in an inert ambient such as nitrogen. The anneal time may be selected to provide a desired composition profile of germanium in the silicon material 202 of the second fin 104-2. For example, in some embodiments, the anneal time may be selected to partially convert the silicon material 202 of the second fin 104-2 that is encapsulated by the Ge-rich SiGe cladding 430 to a silicon germanium material. For example, the anneal time may be less than an hour (e.g., from seconds to about 10-15 minutes) at about 800 degrees Celsius to partially convert the silicon material 202 of the second fin 104-2 to SiGe. An anneal that partially converts the silicon material 202 of the second fin 104-2 to SiGe may provide a Ge-rich surface on the second fin 104-2 relative to the central portion of the second fin 104-2, as is shown in FIG. 4F with the higher-Ge concentration interface portion 206 of the SiGe material 208 and the lower-Ge concentration inner portion of the SiGe material 208, described above. As a result of performing the anneal, part of the second fin 104-2 that is not enclosed by the Ge-rich SiGe cladding 430 but is near the Ge-rich SiGe cladding 430 may also be converted to a SiGe material. This is shown in FIG. 4F with the tail portions of the SiGe material 208 near the sidewalls of the second fin 104-2 just below the Ge-rich SiGe cladding 430, within the portion 204-1 of the second fin 104-2, in areas identified in FIG. 4F with dotted contours 434.

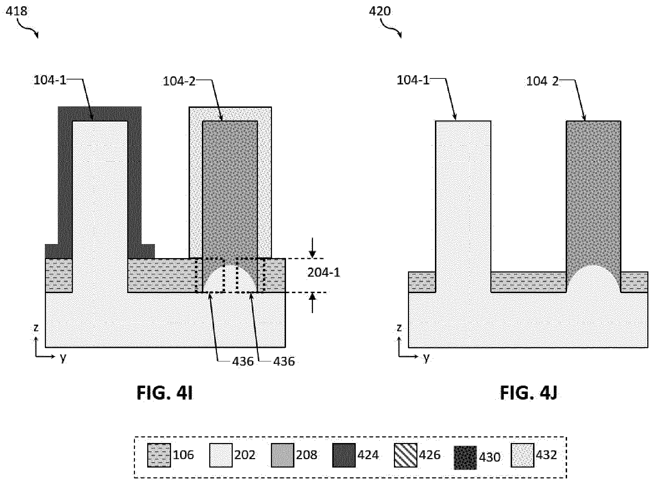

In other embodiments, the anneal time of the process 312 may be selected to fully or substantially fully convert the silicon material 202 of the second fin 104-2 that is encapsulated by the Ge-rich SiGe cladding 430 to a silicon germanium material, a result of which is shown in FIG. 4I as an IC structure 418. In some embodiments, the second fin 104-2 may be fully converted from silicon to SiGe by annealing at about 800 degrees Celsius for about one hour. As shown in FIG. 4I, in this case, all of the silicon material 202 of the second fin 104-2 may be converted to the SiGe material 208, e.g., as described with reference to FIG. 2C. As a result of performing the anneal longer, a further part of the second fin 104-2 that is not enclosed by the Ge-rich SiGe cladding 430 but is near the Ge-rich SiGe cladding 430 may also be converted to a SiGe material. This is shown in FIG. 4I with the tail portions of the SiGe material 208 in areas identified in FIG. 4I with dotted contours 436. As shown in the dotted contours 436, the SiGe material in the fin 104-2 now extends further down towards the base 202, compared to the shorter anneal depicted in FIG. 4F.

The anneal of the process 312 is not limited to the example times, temperatures, and conditions described above and may include other suitable temperatures, anneal times, and anneal conditions in other embodiments of the present disclosure. For example, an anneal time may range from seconds to days depending on a selected temperature and desired composition of SiGe in the second fin 104-2.

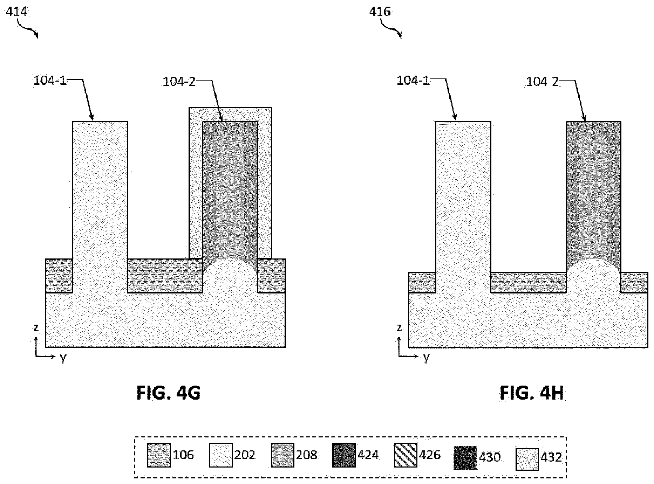

Next, the method 300 may proceed with removing the protective material from the N fin (process 314 shown in FIG. 3, a result of which is illustrated with an IC structure 414, shown in FIG. 4G). The IC structure 414 illustrates that the protective material 424 has been removed from the first fin 104-1. In some embodiments, the process 314 may include using an etch process (e.g., an isotropic etch) with suitable etchants for removing the protective material 424.

The method 300 may also include removing the oxide material from the P fin (process 316 shown in FIG. 3, a result of which is illustrated with an IC structure 416, shown in FIG. 4H). The IC structure 416 illustrates that the oxide material 426 has been removed from the second fin 104-2. In some embodiments, the process 316 may include using an etch process (e.g., an isotropic etch) with suitable etchants for removing the oxide material 426. In some embodiments, the process 316 may be performed before the process 314.

FIG. 4J illustrates an IC structure 420 showing an example result of performing the processes 314 and 316 after the anneal process of process 312 that resulted in creation of the IC structure 418 shown in FIG. 4I.

The method 300 may also include providing source, drain, and gate terminals in the fins 104-1 and 104-2 of the IC structure resulting from performing the processes 302-316 (process 318 shown in FIG. 3, a result of which is not shown in FIG. 4 but could be any of the embodiments shown in FIGS. 2A-2D). The process 318 may include providing the S/D regions 114 in the fins 104, the S/D contacts, and the gate stack 108, as described above, for each of the transistors. Processes for forming these transistor elements are known in the art and, therefore, are not described herein detail.

### Example nanoribbon transistor

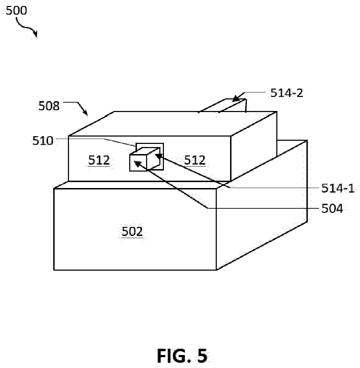

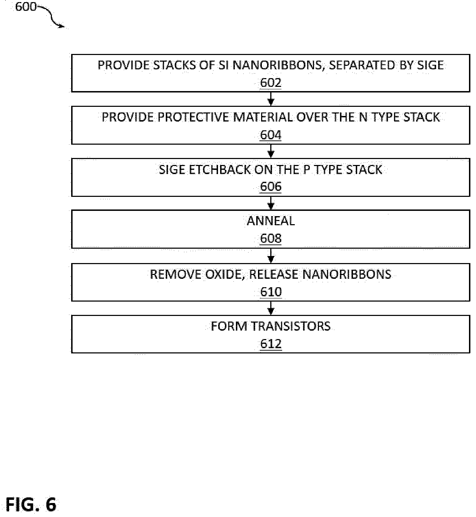

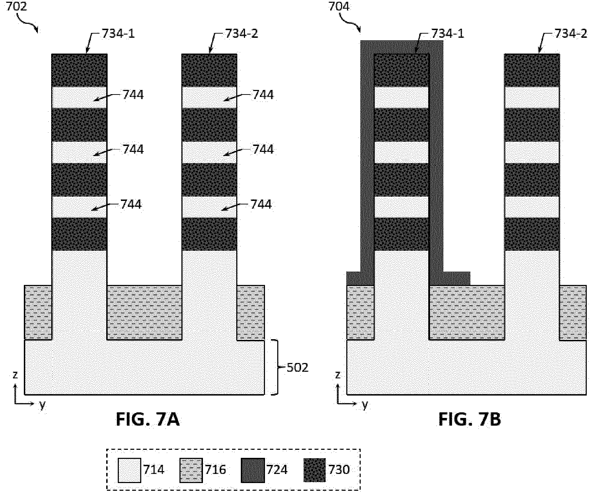

FIG. 5 is a perspective view of an example nanoribbon transistor 500, according to some embodiments of the disclosure, not forming part of the present invention. The nanoribbon transistor 500illustrates an example structure for a non-planar SiGe transistor fabricated using silicon replacement as described herein. For example a plurality of nanoribbons with transistors such as the nanoribbon transistors 500may be used to provide an IC structure having silicon nanoribbon transistors 500 and silicon germanium nanoribbon transistors 500 integrated over a single support structure using silicon replacement, as described with reference to FIG. 6, and FIGS. 7A-7F. The nanoribbon transistor 500 shown in FIG. 5 is intended to show relative arrangement(s) of some of the components therein. In various embodiments, the nanoribbon transistor 500, or portions thereof, may include other components that are not illustrated (e.g., any further materials, such as e.g. spacer materials, surrounding the gate stack of the nanoribbon transistor 500, electrical contacts to the S/D regions of the nanoribbon transistor 500, etc.).

As shown, the nanoribbon transistor 500 of FIG. 5 may include a support structure 502, a nanoribbon 504 provided over the support structure 502, and a gate stack 508 comprising a gate electrode material 512 and, optionally, a gate dielectric 510. Discussions provided above regarding the base 102, the material of the fin 104, the gate electrode material 112, and the gate dielectric 110 are applicable to, respectively, the support structure 502, the material of the nanoribbon 504, the gate electrode material 512, and the gate dielectric 510, and, therefore, in the interests of brevity, are not repeated.

Unlike the fin 104 that extends away from the base 102 in the transistor shown in FIG. 1, the nanoribbon transistor 500 includes a nanoribbon 504 that is provided above the support structure 502. In various embodiments, the nanoribbon 504 may take the form of a nanowire or nanowire, for example. The gate stack 508 may wrap entirely or almost entirely around the nanoribbon 504, as shown, with the channel portion of the nanoribbon 504 corresponding to the portion of the nanoribbon 504 wrapped by the gate stack 508. In particular, the gate dielectric 510 may wrap around the channel material of the nanoribbon 504, and the gate electrode material 512 may wrap around the gate dielectric 510. The nanoribbon 504 may include S/D regions 514 on either side of the gate stack 508, similar to the S/D regions 114 shown in FIG. 1, thus realizing a transistor. The source and drain regions 514-1, 514-2 may be contacted with S/D contacts, not specifically shown in FIG. 5. The transistor 500 may have a gate length (i.e., a distance between the S/D regions 514-1 and 514-2), a dimension measured along the nanoribbon 504, in the direction of the x-axis of an exemplary reference coordinate system x-y-z shown in FIG. 6, which may, in some embodiments, be between about 5 and 40 nanometers, including all values and ranges therein (e.g. between about 22 and 35 nanometers, or between about 15 and 25 nanometers).

Although the nanoribbon 504 illustrated in FIG. 5 is shown as having a rectangular cross-section in a z-y plane of the reference coordinate system shown in FIG. 5, the nanoribbon 504 may instead have a cross-section that is rounded or otherwise irregularly shaped, and the gate stack 508 may conform to the shape of the nanoribbon 504. In use, the nanoribbon transistor 500 may form conducting channels on more than three "sides" of the nanoribbon 504, potentially improving performance relative to FinFETs. In still further embodiments of the nanoribbon transistor 500, the gate stack 508 may be provided over only 3 of the 4 sides of the nanoribbon 504 shown in FIG. 5, thus forming a nanocomb transistor (which may be considered to be one type of the nanoribbon transistor 500).

While FIG. 5 illustrates a single nanoribbon transistor 500, in some embodiments, a plurality of nanoribbon transistors 500 may be arranged next to one another (with some spacing in between) along the nanoribbon 504.

### Example nanoribbon transistor arrangements with SiGe transistors

FIG. 6 is a flow diagram of an example method 600 of fabricating an IC structure having silicon nanoribbons and silicon germanium nanoribbons integrated over a single support structure using silicon replacement, according to some embodiments of the present disclosure, not forming part of the present invention.

Although the operations of the method 600 are illustrated once each and in a particular order, the operations may be performed in any suitable order and repeated as desired. For example, one or more operations may be performed in parallel to manufacture, substantially simultaneously, multiple IC structures and/or multiple SiGe nanoribbon transistors as described herein. In another example, the operations may be performed in a different order to reflect the structure of a particular device assembly in which one or more non-planar SiGe transistors fabricated using silicon replacement as described herein will be included. In addition, the example manufacturing method 600 may include other operations not specifically shown in FIG. 6, such as various cleaning or planarization operations as known in the art, e.g., as those described with reference to the method 300.

Various operations of the method 600 may be illustrated with reference to the example embodiments shown in FIGS. 7A-7F, illustrating fabrication of the IC structures with silicon germanium nanoribbon transistors according to various embodiments described above, but the method 600 may be used to manufacture any suitable IC structures having one or more non-planar SiGe transistors fabricated using silicon replacement according to any embodiments of the present disclosure. FIGS. 7A-7F illustrate cross-sectional side views similar to the view shown in FIGS. 2A-2D (i.e., a cross-section along the y-z plane), in various example stages in the manufacture of an IC structure having silicon nanoribbon transistors and silicon germanium nanoribbon transistors integrated over a single support structure using the method of FIG. 6 in accordance with some embodiments of the present disclosure.

The method 600 may begin with providing at least two stacks over a base, each stack including a plurality of nanoribbons of a silicon material, separated from one another by a Ge-rich silicon germanium material (process 602 shown in FIG. 6, a result of which is illustrated with an IC structure 702, shown in FIG. 7A). The IC structure 702 illustrates the support structure 502 and two stacks 734 (namely, the first stack 734-1 and the second stack 734-2) extending away from the support structure 502. Each stack 734 includes nanoribbons 744 of a silicon material 714, separated by a Ge-rich silicon germanium material 730. A dielectric material 716 may be provided to enclose the lower portions of the stacks 734, similar to the STI 106 described above. The silicon material 714 may include any of the materials described above with reference to the silicon material 202. The Ge-rich silicon germanium material 730 may include any of the materials described above with reference to the Ge-rich silicon germanium material 430. As shown in FIG. 7A, the support structure 502 may also include the silicon material 202. The stacks 734 of nanoribbons 744 may be provided in the process 602 using any suitable deposition and patterning techniques, such as epitaxial deposition of layers of the silicon material 714 alternating with layers of the Ge-rich silicon germanium material 730, followed by any of the patterning techniques known in the art (some of which are described above) to form the stacks 734. One of the two stacks 734 shown in FIG. 7A may be designated as an N stack (i.e., as a stack in which N-type nanoribbon transistors will be provided), e.g., the first stack 734-1, while the other stack may be designated as a P stack (i.e., as a stack in which P-type nanoribbon transistors will be provided), e.g., the second stack 734-2.

The method 600 may then proceed with providing a protective material over the N stack (process 604 shown in FIG. 6, a result of which is illustrated with an IC structure 704, shown in FIG. 7B). The IC structure 704 illustrates a protective material 724 provided as a layer over the N stack 734-1. The protective material 724 may include any of the materials described above with reference to the protective material 424 and may be provided over the N stack 734-1 using a number of processes and intermediate materials (e.g., similar to the processes 304, 306, and a part of the process 308, described above).

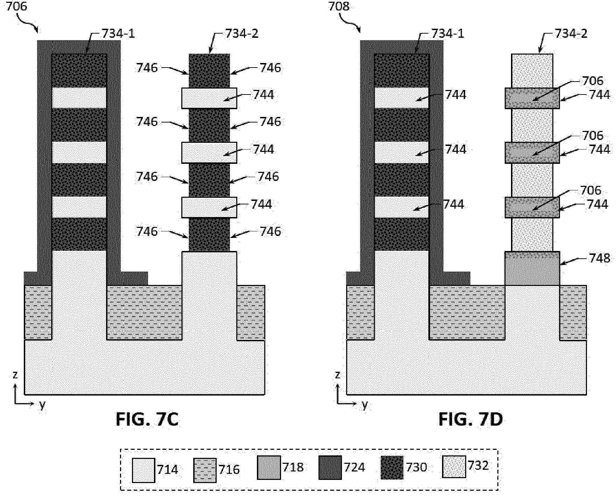

Next, in some embodiments, the method 600 may include an optional process of etching back the SiGe material in the P type stack of the IC structure formed in the process 604 (process 606 shown in FIG. 6, a result of which is illustrated with an IC structure 706, shown in FIG. 7C). The IC structure 706 illustrates that, as a result of the SiGe etchback of the process 606, some of the Ge-rich silicon germanium material 730 may be recessed, laterally (the recessed portions shown in FIG. 7C as portions 746), with respect to the nanoribbons 744 of the silicon material 714. In some embodiments, the width (a dimension measured along the y-axis of the example coordinate system shown) of the Ge-rich silicon germanium material 730 that has been recessed in the portion 746 may be about 20% smaller than the width of the nanoribbons 744, e.g., about 2-10 nanometers smaller. In some embodiments, the process 606 may include performing selective etch of the Ge-rich silicon germanium material 730 with respect to the silicon material 714. Performing the etchback in the process 606 may help with providing a more uniform and a more complete Ge diffusion in the anneal process 608.

The method 600 may then proceed with performing an anneal of the IC structure formed in the process 606 or formed in the process 604, in case the process 606 was not performed, to oxidize the Ge-rich silicon germanium material 730 that is exposed in the P type stack 734-2 (process 608 shown in FIG. 6, a result of which is illustrated with an IC structure 708, shown in FIG. 7D). The IC structure 708 illustrates that, as a result of the anneal, the germanium diffuses from the Ge-rich silicon germanium material 730 in the P type stack 734-2 into the silicon material 714 of the nanoribbons 744 of that stack, thereby converting the silicon material 714 of the nanoribbons 744 of the stack 734-2 into a SiGe material 718 and converting the Ge-rich silicon germanium material 730 to an oxide material 732. In some embodiments, the process 608 may include an anneal as described with reference to the process 312. The anneal time may be selected to provide a desired composition profile of germanium in the silicon material 714 of the nanoribbons 744 in the second stack 734-2. For example, in some embodiments, the anneal time may be selected to partially convert the silicon material 714 of the nanoribbons 744 in the second stack 734-2 to the SiGe material 718. For example, the anneal time may be less than an hour (e.g., from seconds to about 10-15 minutes) at about 800 degrees Celsius to partially convert the silicon material 714 of the nanoribbons 744 in the second stack 734-2 to SiGe. An anneal that partially converts the silicon material 714 of the nanoribbons 744 in the second stack 734-2 to SiGe may provide a Ge-rich surface on the nanoribbons 744 relative to the central portion of the nanoribbons 744, as is shown in FIG. 7D with the higher-Ge concentration interface portion 706 of the SiGe material 718 and the lower-Ge concentration inner portion of the SiGe material 718 in each of the nanoribbons 744 of the second stack 734-2. The portion 706 and the SiGe material 718 are analogous to the portion 206 and the SiGe material 206, described above.

As a result of performing the anneal in the process 608, a portion of the silicon material 714 of the second stack 734-2 that is not supposed to be a nanoribbon for providing transistors therein but is in contact with the Ge-rich silicon germanium material 730 may also be converted to a SiGe material. This is shown in FIG. 7D with a portion 748 of the SiGe material 718.

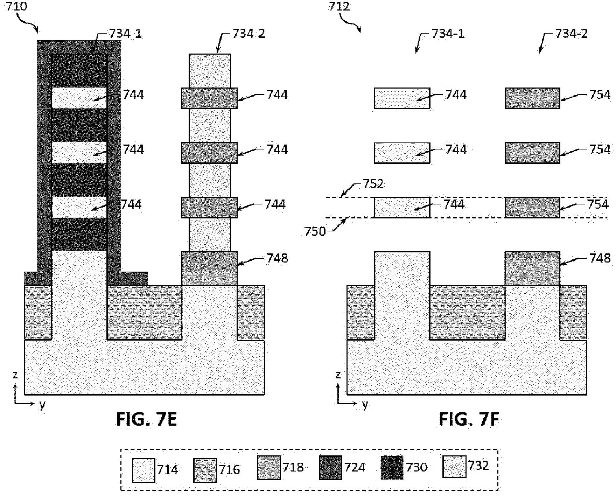

In other embodiments, the anneal time of the process 708 may be selected to fully or substantially fully convert the silicon material 714 of the second stack 734-2 to a silicon germanium material, a result of which is shown in FIG. 7E as an IC structure 710. This longer anneal process may be analogous to the anneal process described with reference to FIG. 4I.

The anneal of the process 708 is not limited to the example times, temperatures, and conditions described above and may include other suitable temperatures, anneal times, and anneal conditions in other embodiments of the present disclosure. For example, an anneal time may range from seconds to days depending on a selected temperature and desired composition of SiGe in the second stack 734-2.

Next, the method 600 may proceed with removing the oxide material 732 from the P stack and removing the Ge-rich SiGe material 730 from the N stack (process 610 shown in FIG. 6, a result of which is illustrated with an IC structure 712, shown in FIG. 7F). The IC structure 712 illustrates that the nanoribbons 744 of the silicon material 714 may remain where the first stack 734-1 used to be, and nanoribbons 754 of the SiGe material 718 may be where the nanoribbons 744 of the silicon material 714 of the second stack 734-2 used to be. Thus, as a result of performing the method 600, the silicon nanoribbons 744 may be aligned with the SiGe nanoribbons 754, e.g., aligned both at the bottom (as shown in FIG. 7F with a line 750 for one pair of Si and SiGe nanoribbons) and at the top (as shown in FIG. 7F with a line 752 for that pair of Si and SiGe nanoribbons). In some embodiments, the process 610 may include using various etch processes with suitable etchants for removing the oxide material 732 from the P stack and removing the Ge-rich SiGe material 730 from the N stack. Although not specifically shown in FIG. 7F, the nanoribbons 744 and 754 may be surrounded by a dielectric material, e.g., any of the materials described with reference to the STI 106.

The method 600 may also include providing source, drain, and gate terminals in the nanoribbons 744 and 754 of the IC structure resulting from performing the processes 602-610, thus forming nanoribbon transistors (process 612 shown in FIG. 6, a result of which is not shown in FIG. 7 but could be any of the embodiments of the nanoribbon transistor shown in FIG. 5). The process 612 may include providing the S/D regions 514 in the nanoribbons 744 and 754, the S/D contacts, and the gate stack 508, as described above, for each of the transistors. Processes for forming these transistor elements are known in the art and, therefore, are not described herein detail.

### Variations and implementations

The IC structures illustrated in FIGS. 1-7 do not represent an exhaustive set of assemblies in which one or more non-planar SiGe transistors fabricated using silicon replacement as described herein may be integrated, but merely provide examples of such structures. For example, although particular arrangements of materials are discussed with reference to FIGS. 1-7, intermediate materials may be included in various portions of these drawings. Additionally, although some elements of the arrangements are illustrated in FIGS. 1-7 as being planar rectangles or formed of rectangular solids, this is simply for ease of illustration, and embodiments of various ones of these elements may be curved, rounded, or otherwise irregularly shaped as dictated by, and sometimes inevitable due to, the manufacturing processes used to fabricate semiconductor device assemblies. For example, while FIGS. 1-7 may illustrate various elements, e.g., the fins 104, nanoribbons 504, etc., as having perfectly straight sidewall profiles, i.e., profiles where the sidewalls extend perpendicularly to the base 102, these idealistic profiles may not always be achievable in real-world manufacturing processes. Therefore, descriptions of various embodiments of non-planar SiGe transistors fabricated using silicon replacement as provided herein are equally applicable to embodiments where various elements of such integrated structures look different from those shown in the drawings due to manufacturing processes used to form them.

Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., Physical Failure Analysis (PFA) would allow determination of the integration of one or more non-planar SiGe transistors fabricated using silicon replacement as described herein within an IC structure. In some implementations, the silicon replacement technique may leave a signature of higher Ge at the interface and can be detected e.g. at the edge of a fin of a FinFET by high resolution TEM cross section. In the case of partially or fully replaced SiGe nanoribbons, nanowires, and/or nanocombs, the height of the NMOS and PMOS may be substantially the same, the position of the nanoribbons, nanowires, and/or nanocombs in height may be substantially the same, with the main difference being that NMOS is Si and PMOS is SiGe. Inspection of a TEM cross section may allow to see in more detail the match in height and characterization techniques such as energy-dispersive X-ray (EDX) spectroscopy or electron energy loss (EEL) spectroscopy can detect any profile in the Ge concentration in the SiGe materials.

### Example electronic devices

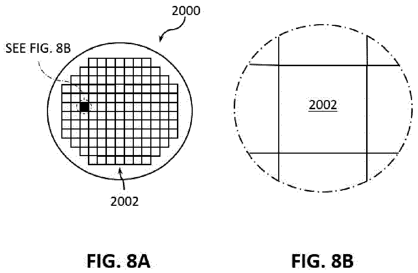

IC structures with one or more non-planar SiGe transistors fabricated using silicon replacement as disclosed herein may be included in any suitable electronic device. FIGS. 8-11 illustrate various examples of devices and components that may include one or more IC structures with non-planar SiGe transistors fabricated using silicon replacement as disclosed herein.

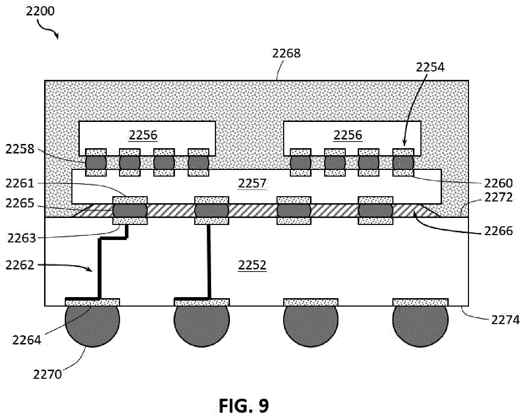

FIGS. 8A-8B are top views of a wafer 2000 and dies 2002 that may include one or more IC structures with non-planar SiGe transistors fabricated using silicon replacement in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 9. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more IC structures with non-planar SiGe transistors fabricated using silicon replacement as described herein). After the fabrication of the semiconductor product is complete (e.g., after manufacture of one or more IC structures with non-planar SiGe transistors fabricated using silicon replacement as described herein), the wafer 2000 may undergo a singulation process in which each of the dies 2002 is separated from one another to provide discrete "chips" of the semiconductor product. In particular, devices that include one or more IC structures with non-planar SiGe transistors fabricated using silicon replacement as disclosed herein may take the form of the wafer 2000 (e.g., not singulated) or the form of the die 2002 (e.g., singulated). The die 2002 may include supporting circuitry to route electrical signals to various memory cells, transistors, capacitors, as well as any other IC components. In some embodiments, the wafer 2000 or the die 2002 may implement or include a memory device (e.g., a DRAM or an SRAM device), a logic device (e.g., an AND, OR, NAND, or NOR gate), or any other suitable circuit element. Multiple ones of these devices may be combined on a single die 2002.

FIG. 9 is a side, cross-sectional view of an example IC package 2200 that may include one or more IC structures with non-planar SiGe transistors fabricated using silicon replacement in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 9 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 9 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

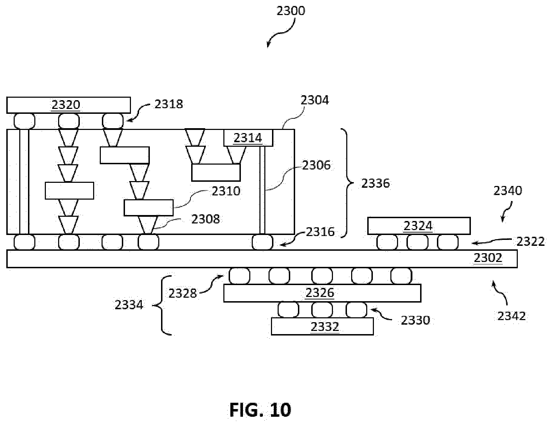

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 9 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 10.

The dies 2256 may take the form of any of the embodiments of the die 2002 discussed herein (e.g., may include any of the embodiments of the IC structures with non-planar SiGe transistors fabricated using silicon replacement as described herein). In embodiments in which the IC package 2200 includes multiple dies 2256, the IC package 2200 may be referred to as a multi-chip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory), including embedded memory dies as described herein. In some embodiments, any of the dies 2256 may include one or more IC structures with non-planar SiGe transistors fabricated using silicon replacement, e.g., as discussed above; in some embodiments, at least some of the dies 2256 may not include any IC structures with non-planar SiGe transistors fabricated using silicon replacement.

The IC package 2200 illustrated in FIG. 9 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 9, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 10 is a cross-sectional side view of an IC device assembly 2300 that may include components having one or more IC structures with non-planar SiGe transistors fabricated using silicon replacement in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more IC structures with non-planar SiGe transistors fabricated using silicon replacement in accordance with any of the embodiments disclosed herein; e.g., any of the IC packages discussed below with reference to the IC device assembly 2300 may take the form of any of the embodiments of the IC package 2200 discussed above with reference to FIG. 9 (e.g., may include one or more IC structures with non-planar SiGe transistors fabricated using silicon replacement provided on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 10 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 10), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 8B), an IC device, or any other suitable component. In particular, the IC package 2320 may include one or more IC structures with non-planar SiGe transistors fabricated using silicon replacement as described herein. Although a single IC package 2320 is shown in FIG. 10, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 10, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as RF devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 10 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

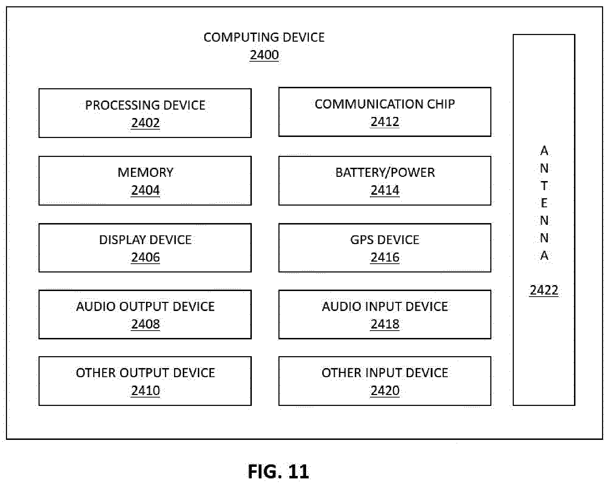

FIG. 11 is a block diagram of an example computing device 2400 that may include one or more components with one or more IC structures with non-planar SiGe transistors fabricated using silicon replacement in accordance with any of the embodiments disclosed herein. For example, any suitable ones of the components of the computing device 2400 may include a die (e.g., the die 2002 (FIG. 8B)) including one or more IC structures with non-planar SiGe transistors fabricated using silicon replacement in accordance with any of the embodiments disclosed herein. Any of the components of the computing device 2400 may include an IC package 2200 (FIG. 9). Any of the components of the computing device 2400 may include an IC device assembly 2300 (FIG. 10).

A number of components are illustrated in FIG. 11 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC die.

Additionally, in various embodiments, the computing device 2400 may not include one or more of the components illustrated in FIG. 11, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402.

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The above description of illustrated implementations of the disclosure, is not intended to be exhaustive or to limit the disclosure to the precise forms disclosed. While specific implementations of, and examples for, the disclosure are described herein for illustrative purposes, various modifications are possible within the scope of the disclosure, as those skilled in the relevant art will recognize.

## Claims

1. An integrated circuit, IC, structure (200A), comprising:
a fin (104-2), extending away from a base (102), comprising a SiGe material, the fin (104-2) comprising a first portion (204-1), a second portion (204-2) and a third portion (204-3), the second portion (204-2) being closest to the base (102), the third portion (204-3) being the portion farthest away from the base (102),
where a concentration of germanium, Ge, near sidewalls of the third portion (204-3) of the fin (104-2) is at least 2 times higher than the concentration of Ge in a middle of the portion of the fin (104-2), wherein the fin (104-2) comprises a tail shape in concentrations of germanium in the SiGe material at sidewalls of the first portion (204-1) of the fin (104-2) decreasing from the third portion (204-3) towards the second portion (204-2); and
a gate stack (108) wrapping around the third portion (204-3) of the fin (104-2), wherein all of the middle of the third portion (204-3) of the fin (104-2) that is wrapped around by the gate stack (108) includes Ge and silicon, Si, with an atomic percentage of Ge being between 20 and 50%.

2. The IC structure (200A) according to claim 1, wherein an atomic percentage of Si in the third portion (204-3) of the fin (104-2) that is wrapped around by the gate stack (108) is below 80%.

3. The IC structure (200A) according to claims 1 or 2, wherein a concentration of Si in the base (102) is at least 2 times higher than in the third portion (204-3) of the fin (104-2) that is wrapped around by the gate stack (108).

4. The IC structure (200A) according to any one of claims 1-3, wherein:
a concentration of Si in the second portion (204-2) **is** the same as the concentration of Si in the base (102).

5. The IC structure (200A) according to claims 2 or 3, wherein:
the fin (104-2) is a second fin (104-2),
the IC structure (200A) further includes a first fin (104-1), extending away from the base (102), and
a concentration of Si in the first fin (104-1) is the same as the concentration of Si in the base (102).

6. The IC structure (200A) according to claim 5, wherein:
the IC structure (200A) further includes a first transistor and a second transistor,
a channel material of the first transistor is a portion of the second fin (104-2),
a channel material of the second transistor is a portion of the first fin (104-1),
the first transistor is a P-type transistor, and
the second transistor is an N-type transistor.

## Patentansprüche

1. Integrierte-Schaltung-bzw. IC-Struktur (200A), die Folgendes umfasst:
eine Finne (104-2), die sich von einer Basis (102) weg erstreckt und ein SiGe-Material umfasst, wobei die Finne (104-2) einen ersten Abschnitt (204-1), einen zweiten Abschnitt (204-2) und einen dritten Abschnitt (204-3) umfasst, wobei der zweite Abschnitt (204-2) der Basis (102) am nächsten ist, wobei der dritte Abschnitt (204-3) der von der Basis (102) am weitesten entfernte Abschnitt ist,
wobei eine Konzentration von Germanium, Ge, in der Nähe von Seitenwänden des dritten Abschnitts (204-3) der Finne (104-2) mindestens 2-mal höher ist als die Konzentration von Ge in einer Mitte des Abschnitts der Finne (104-2),
wobei die Finne (104-2) eine Schwanzform in Konzentrationen von Germanium in dem SiGe-Material an Seitenwänden des ersten Abschnitts (204-1) der Finne (104-2) umfasst, die von dem dritten Abschnitt (204-3) in Richtung des zweiten Abschnitts (204-2) abnimmt; und einen Gate-Stapel (108), der den dritten Abschnitt (204-3) der Finne (104-2) umhüllt, wobei die gesamte Mitte des dritten Abschnitts (204-3) der Finne (104-2), der von dem Gate-Stapel (108) umhüllt wird, Ge und Silicium, Si, aufweist, wobei ein atomarer Anteil von Ge zwischen 20 und 50 % liegt.

2. IC-Struktur (200A) nach Anspruch 1, wobei ein atomarer Anteil von Si in dem dritten Abschnitt (204-3) der Finne (104-2), der von dem Gate-Stapel (108) umhüllt wird, unter 80 % liegt.

3. IC-Struktur (200A) nach Anspruch 1 oder 2, wobei eine Konzentration von Si in der Basis (102) mindestens 2-mal höher ist als in dem dritten Abschnitt (204-3) der Finne (104-2), der von dem Gate-Stapel (108) umhüllt wird.

4. IC-Struktur (200A) nach einem der Ansprüche 1-3, wobei:
eine Konzentration von Si in dem zweiten Abschnitt (204-2) die gleiche wie die Konzentration von Si in der Basis (102) ist.

5. IC-Struktur (200A) nach Ansprüchen 2 oder 3, wobei:
die Finne (104-2) eine zweite Finne (104-2) ist,
die IC-Struktur (200A) ferner eine erste Finne (104-1) aufweist, die sich von der Basis (102) weg erstreckt, und
eine Konzentration von Si in der ersten Finne (104-1) die gleiche wie die Konzentration von Si in der Basis (102) ist.

6. IC-Struktur (200A) nach Anspruch 5, wobei:
die IC-Struktur (200A) ferner einen ersten Transistor und
einen zweiten Transistor aufweist,
ein Kanalmaterial des ersten Transistors ein Abschnitt der zweiten Finne (104-2) ist,
ein Kanalmaterial des zweiten Transistors ein Abschnitt der ersten Finne (104-1) ist,
der erste Transistor ein P-Transistor ist und
der zweite Transistor ein N-Transistor ist.

## Revendications

1. Structure de circuit intégré, noté CI, (200A), comprenant :
une ailette (104-2), s'étendant à partir d'une base (102), comprenant un matériau SiGe, l'ailette (104-2) comprenant une première partie (204-1), une deuxième partie (204-2) et une troisième partie (204-3), la deuxième partie (204-2) étant la plus proche de la base (102), la troisième partie (204-3) étant la plus éloignée de la base (102),
une concentration de germanium, noté Ge, près de parois latérales de la troisième partie (204-3) de l'ailette (104-2) étant au moins 2 fois supérieure à la concentration de Ge au milieu de la partie de l'ailette (104-2), l'ailette (104-2) comprenant un profil en queue de concentrations de germanium dans le matériau SiGe au niveau des parois latérales de la première partie (204-1) de l'ailette (104-2) qui décroît de la troisième partie (204-3) vers la deuxième partie (204-2) ; et
un empilement de grille (108) enveloppant la troisième partie (204-3) de l'ailette (104-2), tout le milieu de la troisième partie (204-3) de l'ailette (104-2) qui est enveloppée par l'empilement de grille (108) comportant du Ge et du silicium, noté Si, avec un pourcentage atomique de Ge compris entre 20 et 50 %.

2. Structure de CI (200A) selon la revendication 1, dans laquelle un pourcentage atomique de Si dans la troisième partie (204-3) de l'ailette (104-2) qui est enveloppée par l'empilement de grille (108) est inférieur à 80 %.

3. Structure de CI (200A) selon les revendications 1 ou 2, dans laquelle une concentration de Si dans la base (102) est au moins 2 fois supérieure à celle dans la troisième partie (204-3) de l'ailette (104-2) qui est enveloppée par l'empilement de grille (108).

4. Structure de CI (200A) selon l'une quelconque des revendications 1 à 3, dans laquelle :
une concentration de Si dans la deuxième partie (204-2) est identique à la concentration de Si dans la base (102).

5. Structure de CI (200A) selon les revendications 2 ou 3, dans laquelle :
l'ailette (104-2) est une deuxième ailette (104-2),
la structure de CI (200A) comporte en outre une première ailette (104-1) s'étendant à partir de la base (102), et
une concentration de Si dans la première ailette (104-1) est identique à la concentration de Si dans la base (102).

6. Structure de CI (200A) selon la revendication 5, dans laquelle :
la structure de CI (200A) comporte en outre un premier transistor et un deuxième transistor,
un matériau de canal du premier transistor forme une partie de la deuxième ailette (104-2),
un matériau de canal du deuxième transistor forme une partie de la première ailette (104-1),
le premier transistor est un transistor du type P, et
le deuxième transistor est un transistor du type N.
